# EUROPEAN PATENT APPLICATION

(11) **EP 4 421 864 A1**
(43) Date of publication of application: **28.08.2024**
(21) Application number: 24157974.7
(22) Date of filing: 15.02.2024
(51) Int. Cl.: H01L 23/367, H01L 23/373, H01L 23/42

(54) **SEMICONDUCTOR DEVICE AND MANUFACTURING METHOD THEREOF**

(30) Priority: 23.02.2023 US 202363486485 P; 25.01.2024 US 202418422166
(71) Applicant: MediaTek Inc., 30078 Hsinchu City (TW)
(72) Inventor: LIN, Chun-Yin, Hsinchu City (TW); LI, Yu-Jin, Hsinchu City (TW); CHEN, Tai-Yu, Hsinchu City (TW); HUANG, Pu-Shan, Hsinchu City (TW)
(74) Representative: Wright, Howard Hugh Burnby

(57) **Abstract**

A semiconductor device includes a substrate, an electronic component, a cover and a liquid metal. The electronic component is disposed on the substrate. The cover is disposed on the substrate, coves the electronic component and has a recess. The liquid metal is formed between the recess and the electronic component.

## Description

### FIELD OF THE INVENTION

The invention relates to a semiconductor device and a manufacturing method thereof, and more particularly to a semiconductor device including a liquid metal and a manufacturing method thereof.

### BACKGROUND OF THE INVENTION

Conventional semiconductor device includes a substrate and an electronic component disposed on the substrate. However, the electronic component inevitably generates heat during operation. Thus, how to dissipate the heat from the electronic component has become a prominent task for the industries.

### SUMMARY OF THE INVENTION

In one embodiment of the invention, a semiconductor device is provided. The semiconductor device includes a substrate, an electronic component, a cover and a liquid metal. The electronic component is disposed on the substrate. The cover is disposed on the substrate, coves the electronic component and has a recess. The liquid metal is formed between the recess and the electronic component.

In another embodiment of the invention, a semiconductor method is provided. The manufacturing method includes the following steps: disposing an electronic component on a substrate; disposing a cover on the substrate to cover the electronic component, wherein the cover has recess; and forming a liquid metal between the recess and the electronic component.

Numerous objects, features and advantages of the invention will be readily apparent upon a reading of the following detailed description of embodiments of the invention when taken in conjunction with the accompanying drawings. However, the drawings employed herein are for the purpose of descriptions and should not be regarded as limiting.

### BRIEF DESCRIPTION OF THE DRAWINGS

The above objects and advantages of the invention will become more readily apparent to those ordinarily skilled in the art after reviewing the following detailed description and accompanying drawings, in which:
FIG. 1A illustrates a diagram view of a top view of a semiconductor device according to an embodiment of the invention;
FIG. 1B illustrates a cross-sectional views of the semiconductor device of FIG. 1A along a direction 1B-1B';
FIG. 1C illustrates a diagram view of a bottom view of a cover of FIG. 1B;
FIGS. 2A to 2E illustrate manufacturing processes of the semiconductor device of FIG. 1B;
FIG. 3A illustrates a diagram view of a top view of a semiconductor device disposed on a PCB according to an embodiment of the invention;
FIG. 3B illustrates a cross-sectional view of the semiconductor device of FIG. 3A along a direction 3B-3B';
FIG. 4A illustrates a diagram view of a top view of a semiconductor device according to an embodiment of the invention;
FIG. 4B illustrates a cross-sectional view of the semiconductor device of FIG. 4A along a direction 4B-4B';
FIGS. 5A to 5D illustrate manufacturing processes of the semiconductor device of FIG. 3A; and
FIGS. 6A to 6B illustrate manufacturing processes of the semiconductor device of FIG. 4A.

### DETAILED DESCRIPTION OF PREFERRED EMBODIMENTS

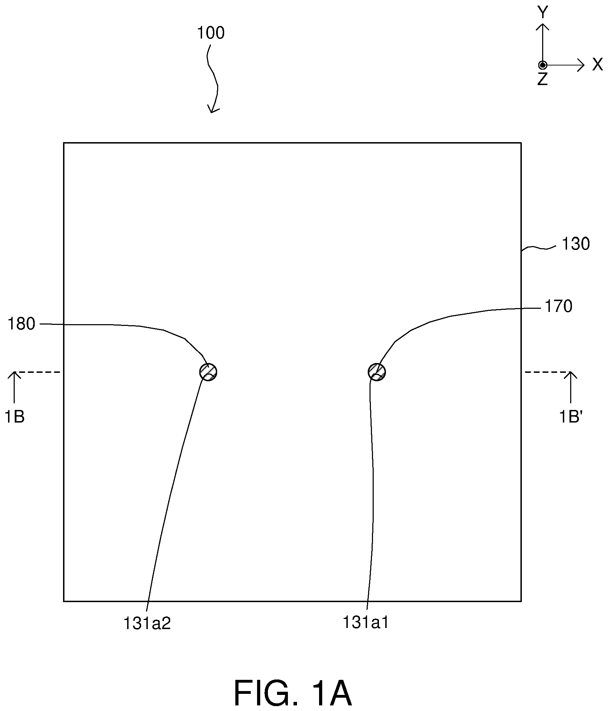

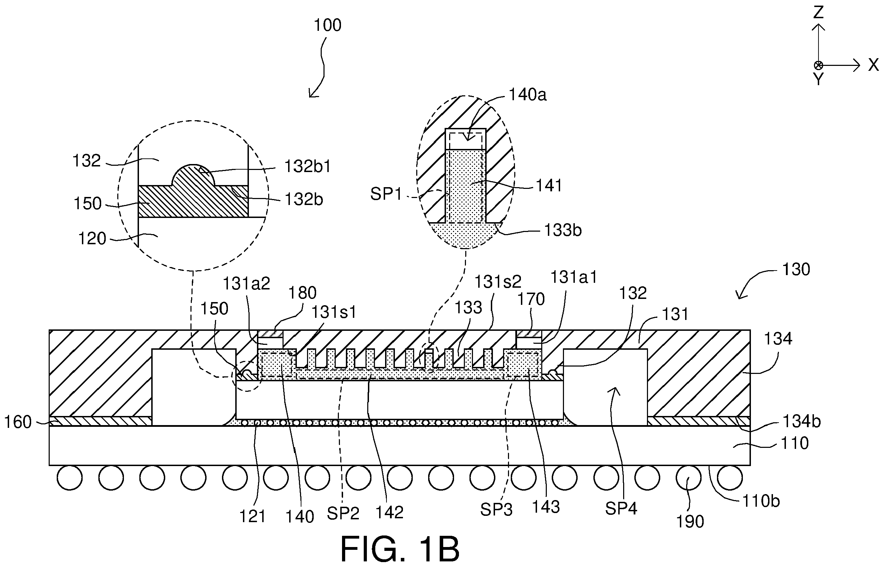

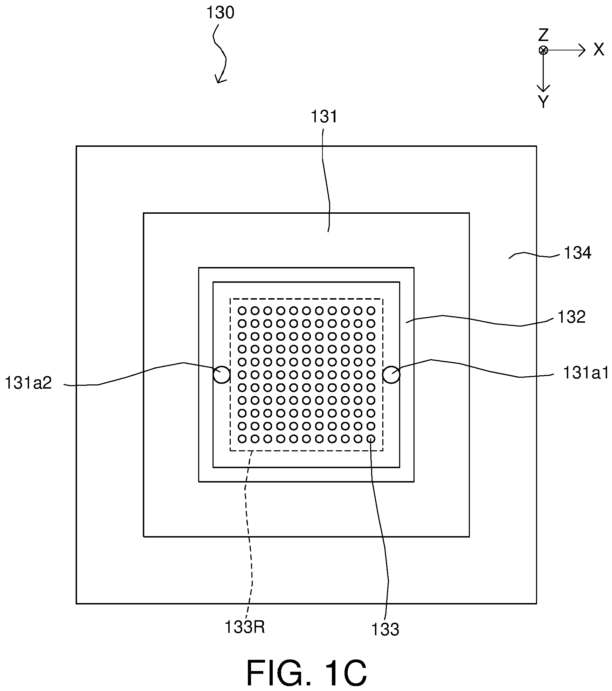

Referring to FIGS. 1A to 1C, FIG. 1A illustrates a diagram view of a top view of a semiconductor device 100 according to an embodiment of the invention, FIG. 1B illustrates a cross-sectional view of the semiconductor device 100 of FIG. 1A along a direction 1B-1B', and FIG. 1C illustrates a diagram view of a bottom view of a cover 130 of FIG. 1B.

The semiconductor device 100 is, for example, a Flip Chip Ball Grid Array (FCBGA), such as a High Performance FCBGA; however, such exemplification is not meant to be for limiting.

As illustrated in FIGS. 1A and 1B, the semiconductor device 100 includes a substrate 110, an electronic component 120, a cover 130, a liquid metal 140, a first adhesive layer 150, a second adhesive layer 160, a first seal 170, a second seal 180 and at least one conductive portion 190.

As illustrated in FIG. 1B, the electronic component 120 is disposed on the substrate 110. The cover 130 is disposed on the substrate 110 and covers the electronic component 120. The liquid metal 140 is formed between the cover 130 and the electronic component 120. As a result, the heat generated by the electronic component 120 could be dissipated through the liquid metal 140 and the cover 130.

The substrate 110 has, for example, single-layered structure or multilayered structure. Although not illustrated, the substrate 110 includes at least one conductive trace, at least one conductive via and /or at least one conductive pad, wherein the conductive traces are electrically connected with at least one conductive via. In an embodiment, the substrate 110 is, for example, a printed circuit board (PCB), an interposer, another semiconductor device or a semiconductor package.

The electronic component 120 is electrically connected with the conductive portion 190 through the substrate 110. The electronic component 120 is, for example, the component capable of applying to (or disposed on) a package requiring high-power operation, such as Flip Chip BGA (FCBGA), Fan-out package, 3D (three-dimension) IC (Integrated Circuit) package, etc. The electronic component 120 includes at least one conductive portion 121, wherein the conductive portion 121 is, for example, bump or solder ball. The electronic component 120 is bonded to the at least one conductive pad (not illustrated) of the substrate 110 through at least one conductive portion 121.

The cover 130 is made by a material, for example, metal, such as copper, aluminum, iron or a combination thereof. The cover 130 could conduct heat and increased strength of the semiconductor device 100 for reducing warpage.

As illustrated in FIGS. 1B and 1C, the cover 130 includes a plate 131, a first surrounding portion 132, at least one pillar 133 and a second surrounding portion 134. The plate 131 has a first surface 131s1 and a second surface 131s2 opposite to the first surface 131s1. The first surface 131s1 faces the electronic component 120. The first surrounding portion 132, the pillars 133 and the second surrounding portion 134 are disposed on the plate 131 and protrude with respect to (or relative to) the first surface 131s1. The first surrounding portion 132 is, for example, a closed-ring for surrounding the whole of the liquid metal 140. Since the pillars 133 protrude with respect to the first surface 131s1, and accordingly it could increase heat conduction area of the cover 130. The second surrounding portion 134 surrounds the first surrounding portion 132, the pillars 133, the electronic component 120 and the liquid metal 140. The second surrounding portion 134 is a closed-ring for surrounding the whole of the first surrounding portion 132, the pillars 133, the electronic component 120 and the liquid metal 140.

As illustrated in FIGS. 1A to 1C, the cover 130 has a first through hole 131a1 and a second through hole 131a2. In the present embodiment, the first through hole 131a1 and the second through hole 131a2 are located at the plate 131. For example, the first through hole 131a1 and the second through hole 131a2 both extend to the second surface 131s2 from the first surface 131s1. As a result, during injection of the liquid metal 140, the liquid metal 140 flows into through the first through hole 131a1, and air (if any) could be discharged through the second through hole 131a2.

As illustrated in FIGS. 1A to 1C, the first through hole 131a1 and the second through hole 131a2 are located adjacent to first surrounding portion 132. The first through hole 131a1 and the second through hole 131a2 are located between the whole region 133R of the pillars 133 and the first surrounding portion 132. In the present embodiment, the first through hole 131a1 and the second through hole 131a2 are disposed at two opposite sides of the whole region 133R or the first surrounding portion 132, and thus distance between the first through hole 131a1 and the second through hole 131a2 is long. As a result, during injection of the liquid metal 140, the liquid metal 140 flows into through the first through hole 131a1, and most air could be discharged through the second through hole 131a2. In another embodiment, the first through hole 131a1 and the second through hole 131a2 could be disposed at two opposite corners of the whole region 133R or the first surrounding portion 132 (that is, at two end of the diagonal line of the whole region 133R or the first surrounding portion 132). As a result, the distance between the first through hole 131a1 and the second through hole 131a2 is longest, and accordingly it is more conducive to exhausting the air. In another embodiment, the second through hole 131a2 could be omitted, and the first through hole 131a1 could be disposed at middle position of the second surface 131s2 of the plate 131 or other position of the plate 130.

In terms of the property, the liquid metal 140 has melting point ranging between 60°C to 70°C, less or higher. During injection of the liquid metal 140, the liquid metal 140 is pre-heated to be at flowable state, injected into space between the cover 130 and the electronic component 120 through the first through hole 131a1, and then solidified, without curing, by cooling or temperature drop. In addition, the liquid metal 140 has thermal conductivity ranging between the 70 W/m-K to 80 W/m-K, or higher. The thermal conductivity of the liquid metal 140 is higher than that of the thermal Interface Material (TIM). Generally, the TIM has thermal conductivity ranging between 2 W/m-K to 5 W/m-K.

As illustrated in FIG. 1B, the liquid metal 140 is formed among the cover 130 and the electronic component 120 as a heat transfer medium. Furthermore, there are a first receiving portion SP1 formed between adjacent two pillars 133, a second receiving portion SP2 formed between a terminal 133b of each pillar 133 and the electronic component 120, and a third receiving portion SP3 formed between the first surrounding portion 132, the first surface 131s1, the outermost pillar 133 and the electronic component 120. Viewed from top of the third receiving portion SP3, the third receiving portion SP3 has a ringed-shape, for example, a closed ringed-shape. The liquid metal 140 includes at least one first metal portion 141, a second metal portion 142 and a third metal portion 143. The first metal portion 141 fills up at least portion of each first receiving portion SP1, the second metal portion 142 fills up at least portion of the second receiving portion SP2, and the third metal portion 143 fills up at least portion of the third receiving portion SP3. As a result, even if the liquid metal 140 has at least one void (or air layer) 140a, the heat generated by the electronic component 120 still could be dissipated through other heat conduction part, such as the first metal portion 141, the second metal portion 142 and the third metal portion 143 which connect the cover 130 and electronic component 120.

In addition, as illustrated in FIG. 1B, there is space SP4 formed among the plate 131, the first surrounding portion 132 and the second surrounding portion 134. There is no physical material formed within the space SP4, for example.

As illustrated in FIG. 1B, the first adhesive layer 150 is disposed between a terminal 132b of the first surrounding portion 132 and the electronic component 120 for fixing relative position between the first surrounding portion 132 and the electronic component 120. In an embodiment, viewed from top of the first adhesive layer 150, the first adhesive layer 150 has a ringed-shape, for example, a closed ringed-shape for closing the gap (if any) between the first surrounding portion 132 and the electronic component 120. As a result, the liquid metal 140 could be prevented from leaking through the first surrounding portion 132 and the electronic component 120. In addition, the terminal 132b has a concave 132b1 for receiving a portion of the first adhesive layer 150, and accordingly it could increase adhesion between the first surrounding portion 132 and the electronic component 120.

As illustrated in FIG. 1B, the second adhesive layer 160 is disposed between a terminal 134b of the second surrounding portion 134 and the substrate 110 for fixing relative position between the cover 130 and the substrate 110. In an embodiment, viewed from top of the second adhesive layer 160, the second adhesive layer 160 has a ringed-shape, for example, a closed ringed-shape for closing the gap (if any) between the second surrounding portion 134 and the substrate 110. As a result, an external impurity is prevented from invading interior of the semiconductor device 100 through the second surrounding portion 134 and the substrate 110.

As illustrated in FIG. 1B, the first seal 170 closes or seals the first through hole 131a1. As a result, the liquid metal 140 is prevented from leaking through the first through hole 131a1, and an external impurity is prevented from invading an interior of the semiconductor device 100 through the first through hole 131a1. In addition, there is space between the first seal 170 and the third metal portion 143 of the liquid metal 140, and there is no physical material formed within the space, and thus the space could receive the thermal expansion of the third metal portion 143.

As illustrated in FIG. 1B, the second seal 180 closes the second through hole 131a2. As a result, the liquid metal 140 is prevented from leaking through the second through hole 131a2, and an external impurity is prevented from invading an interior of the semiconductor device 100 through the second through hole 131a2. In addition, there is space between the second seal 180 and the third metal portion 143 of the liquid metal 140, and there is no physical material formed within the space, and thus the space could receive the thermal expansion of the third metal portion 143.

As illustrated in FIG. 1B, the first adhesive layer 150, the second adhesive layer 160, the first seal 170 and the second seal 180 seal the receiving portions among the cover 130 and the electronic component 120 within.

As illustrated in FIG. 1B, the conductive portions 190 are formed on a lower surface 110b of the substrate 110. Any one of the conductive portions 190 is, for example, bump, solder ball, etc. The semiconductor device 100 is bonded to and electrically connected with an external electronic device (for example, PCB, etc.) through the conductive portions 190 of the semiconductor device 100.

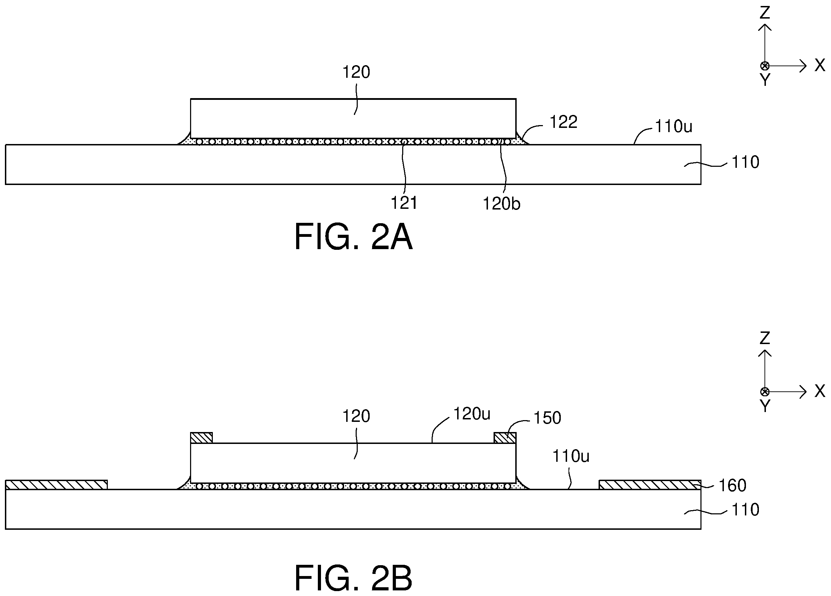

Referring to FIGS. 2A to 2E, FIGS. 2A to 2E illustrate manufacturing processes of the semiconductor device 100 of FIG. 1B.

As illustrated in FIG. 2A, the electronic component 120 is disposed on the substrate 110, wherein the electronic component 120 includes at least one conductive portion 121, wherein the electronic component 120 is bonded to the substrate 110 through at least one conductive portion 121. In addition, an underfill 122 is formed between a lower surface 120b of the electronic component 120 and an upper surface 110u of the substrate 110 to encapsulate the conductive portions 121.

As illustrated in FIG. 2B, the first adhesive layer 150 is formed on an upper surface 120u of the electronic component 120, wherein the first adhesive layer 150 is formed on an peripheral zone of the upper surface 120u. Viewed from top of the first adhesive layer 150, the first adhesive layer 150 has a ringed-shape, for example, a closed ringed-shape.

As illustrated in FIG. 2B, the second adhesive layer 160 is formed on the upper surface 110u of the substrate 110, wherein the second adhesive layer 160 is formed on an peripheral zone of the upper surface 110u. Viewed from top of the second adhesive layer 160, the second adhesive layer 160 has a ringed-shape, for example, a closed ringed-shape.

In addition, the embodiment of the present invention does not limit the order of forming the first adhesive layer 150 and the second adhesive layer 160.

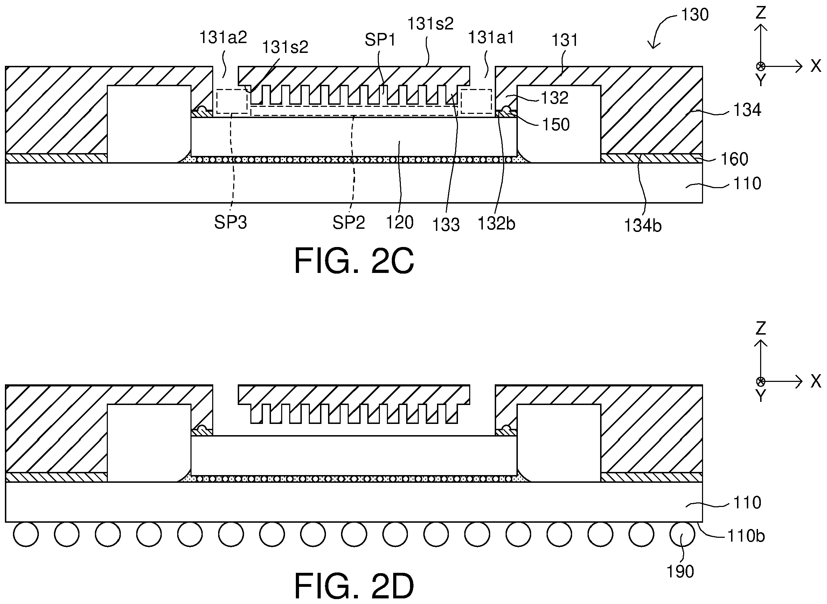

As illustrated in FIG. 2C, the cover 130 is disposed on the substrate 110 to cover the electronic component 120. The cover 130 includes the plate 131, the first surrounding portion 132, at least one pillar 133 and the second surrounding portion 134. The cover 130 has the first through hole 131a1 and the second through hole 131a2, wherein the first through hole 131a1 and the second through hole 131a2 both extend to the second surface 131s2 of the plate 131 from the first surface 131s1 of the plate 131.

In FIG. 2C, the first surrounding portion 132 of the cover 130 adheres to the electronic component 120 through the first adhesive layer 150, and the second surrounding portion 134 of the cover 130 adheres to the substrate 110 through the second adhesive layer 160 for fixing the relative position between the substrate 110 and the cover 130. The first adhesive layer 150 could close the gap (if any) between the first surrounding portion 132 and the electronic component 120, and the second adhesive layer 160 could close the gap (if any) between the second surrounding portion 134 and the substrate 110.

In FIG. 2C, there are the first receiving portion SP1 formed between adjacent two pillars 133, the second receiving portion SP2 formed between the terminal 133b of each pillar 133 and the electronic component 120, and the third receiving portion SP3 formed between the first surrounding portion 132, the first surface 131s1, the outermost pillar 133 and the electronic component 120. Viewed from top of the third receiving portion SP3, the third receiving portion SP3 has a ringed-shape, for example, a closed ringed-shape.

As illustrated in FIG. 2D, at least one conductive portion 190 is formed on the lower 110b of the substrate 110.

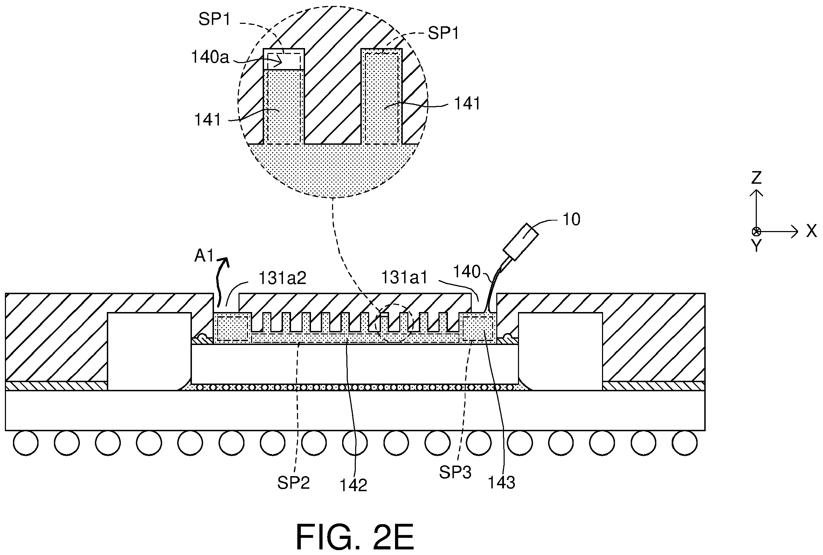

As illustrated in FIG. 2E, the liquid metal 140 is formed between the cover 130 and the electronic component 120 by using injector 10. For example, the liquid metal 140 is injected into the first receiving portion SP1, the second receiving portion SP2 and the third receiving portion SP3 through the first through hole 131a1, and gas (for example, air) A1 is discharged through the second through hole 131a2.

In FIG. 2E, the liquid metal 140 includes at least one first metal portion 141, the second metal portion 142 and the third metal portion 143. The first metal portion 141 fills up at least portion of each first receiving portion SP1, the second metal portion 142 fills up at least portion of the second receiving portion SP2, and the third metal portion 143 fills up at least portion of the third receiving portion SP3. Due to many portions (for example, the first metal portions 141, the second metal portion 142 and the third metal portion 143) connecting the cover 130 and electronic component 120, even if the liquid metal 140 has at least one void (or air layer) 140a, the heat generated by the electronic component 120 still could be dissipated through other heat conduction part, such as the first metal portion 141, the second metal portion 142 and the third metal portion 143 which connect the cover 130 and electronic component 120.

Then, the first seal 170 is formed within the first through hole 131a1 to seal the first through hole 131a1, as illustrated in FIG. 1B. As a result, the liquid metal 140 is prevented from leaking through the first through hole 131a1, and an external impurity is prevented from invading an interior of the semiconductor device 100 through the first through hole 131a1. In addition, there is space between the first seal 170 and the third metal portion 143 of the liquid metal 140, and there is no physical material formed within the space, and thus the space could receive the thermal expansion of the third metal portion 143.

Then, the second seal 180 is formed within the second through hole 131a2 to seal the second through hole 131a2, as illustrated in FIG. 1B. As a result, the liquid metal 140 is prevented from leaking through the second through hole 131a2, and an external impurity is prevented from invading an interior of the semiconductor device 100 through the second through hole 131a2. In addition, there is space between the second seal 180 and the third metal portion 143 of the liquid metal 140, and there is no physical material formed within the space, and thus the space could receive the thermal expansion of the third metal portion 143.

In addition, the embodiment of the present invention does not limit the order of forming the first seal 170 and the second seal 180.

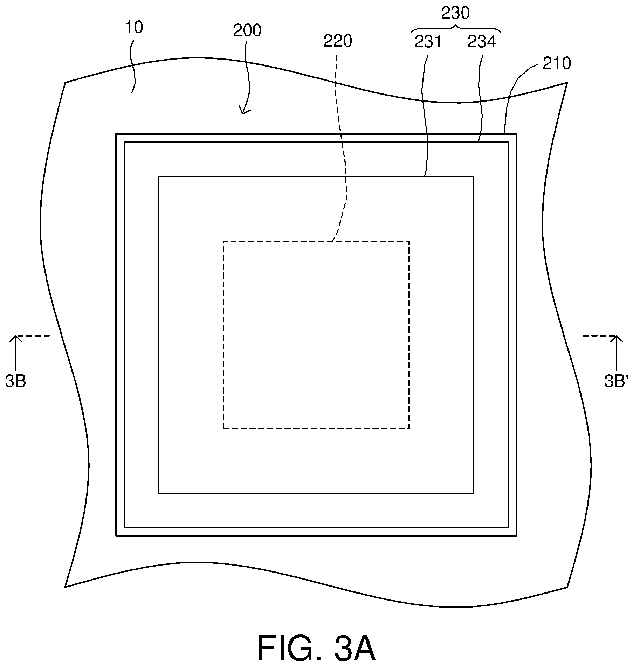

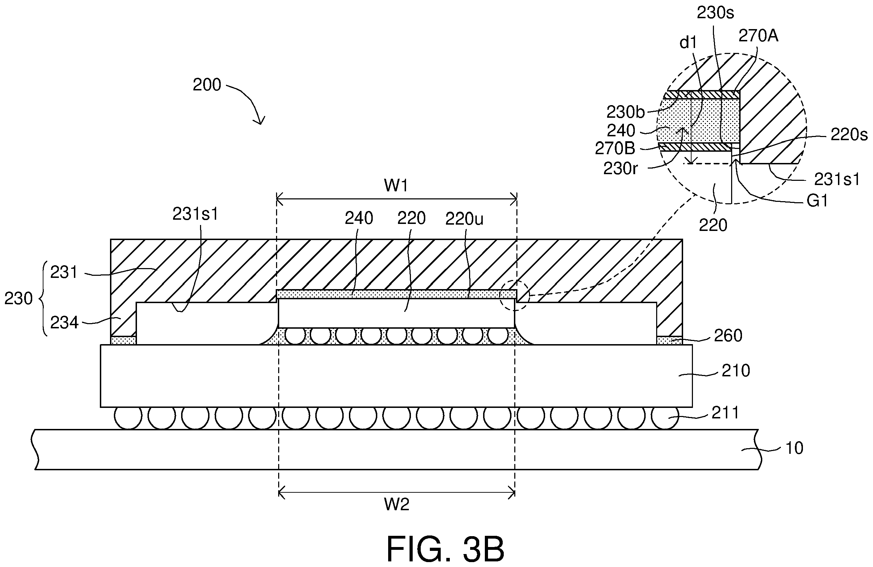

Referring to FIGS. 3A to 3B, FIG. 3A illustrates a diagram view of a top view of a semiconductor device 200 disposed on a PCB 10 according to an embodiment of the invention, and FIG. 3B illustrates a cross-sectional view of the semiconductor device 200 of FIG. 3A along a direction 3B-3B'.

As illustrated in FIGS. 3A and 3B, the semiconductor device 200 includes a substrate 210, at least one electronic component 220, a cover 230, a liquid metal 240, an adhesive layer 260, a first binding promoting layer 270A and a second binding promoting layer 270B. The electronic component 220 is disposed on the substrate 210. The cover 230 is disposed on the substrate 210, covers the electronic component 220 and has a recess 230r. The liquid metal 240 is formed between the recess 230r and the electronic component 220. As a result, the recess 230r and the electronic component 220 could limit the flowing of the liquid metal 240 to prevent the liquid metal 240 from being overflow.

As illustrated in FIG. 3B, the liquid metal 240 fills the recess 230r. As a result, the recess 230r may recess the liquid metal 240 for preventing the liquid metal 240 from being overflow.

As illustrated in FIG. 3B, the semiconductor device 200 could be disposed on and electrically connected to the PCB 10 through at least one solder ball 211 of the substrate 210. The solder ball 211 may be formed on the substrate 210 during a reflow process at a temperature of about 230 °C to about 260 °C.

The substrate 210 includes the features the same as or similar to that of the substrate 110, the electronic component 220 includes the features the same as or similar to that of the electronic component 120, and they will be not repeated here. In addition, the liquid metal 240 incudes a material property the same as or similar to that of the liquid metal 140, and it will not be repeated here.

As illustrated in FIG 3B, the electronic component 220 has an upper surface 220u. The cover 230 includes a plate 231. The plate 231 has a first surface 231s1 facing the electronic component 220. The recess 230r is recessed with respect to the first surface 231s1. The first surface 231s1 is lower than the upper surface 220u of the electronic component 220. As a result, a gap G1 (if any) between a lateral surface 230s of the recess 230r and a lateral surface 220s of the electronic component 220 could block an overflow of the liquid metal 240. In addition, the help the electronic component 220 to easily enter the recess 230r.

As illustrated in FIG 3B, the recess 230r has a first width W1, the electronic component 220 has a second width W2, and the first width W1 is greater the second width W2. As a result, the electronic component 220 could enter the recess 230r for positioning a position between the electronic component 220 and he recess 230r, and it is conducive to the assembly of the recess 230r and the electronic component 220. In an embodiment, a ratio of the first width W1 to the second width W2 could range between 1.05 and 1.10, less or greater. In addition, the recess 230r has a depth d1 ranging between 20 µm and 500 µm, less or greater.

As illustrated in FIG 3B, the recess 230r has a bottom surface 230b, wherein the lateral surface 230s is vertical to the bottom surface 230b. In other words, the lateral surface 230s is a vertical wall. In an embodiment, the recess 230r could be formed by, for example, a forging process or a machining process.

As illustrated in FIG 3B, the cover 230 further includes a surrounding portion 234, wherein the surrounding portion 234 is disposed on the plate 231 and protrudes with respect to the first surface 231s1. In an embodiment, the cover 230 could be formed by, for example, a forging process.

The liquid metal 240 has melting point ranging between, for example, about 100 °C to about 200 °C, even lower or higher. During reflow process for a solder ball 211 of the substrate 210 and/or curing process for the adhesive layer 260, the recess 230r could prevent the liquid metal 240 from being overflow even if the liquid metal 240 may be changed to a liquid (or fluidity) phase.

The adhesive layer 260 is formed between the surrounding portion 234 and the substrate 210 for fixing a relative position between the substrate 210 and the cover 230. The adhesive layer 260 fixes relative position between the substrate 210 and the cover 230 after being cured at a temperature of about 120 °C to about 150 °C.

As illustrated in FIG 3B, the first binding promoting layers 270A could be formed between the liquid metal 240 and the cover 230 for increasing the combination of the liquid metal 240 and the cover 230, and the second binding promoting layers 270B could be formed between the liquid metal 240 and the electronic component 220 for increasing the combination of the liquid metal 240 and the electronic component 220. In an embodiment, the first binding promoting layers 270A and the second binding promoting layers 270B are, for example, Au coating layer.

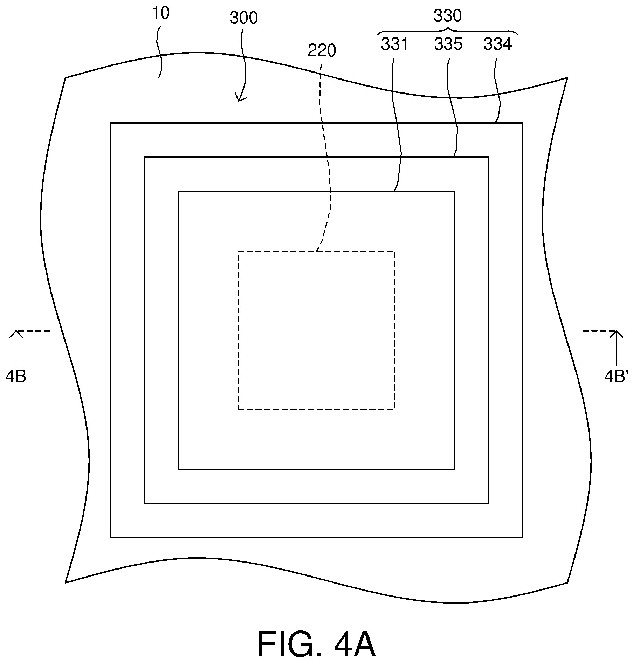

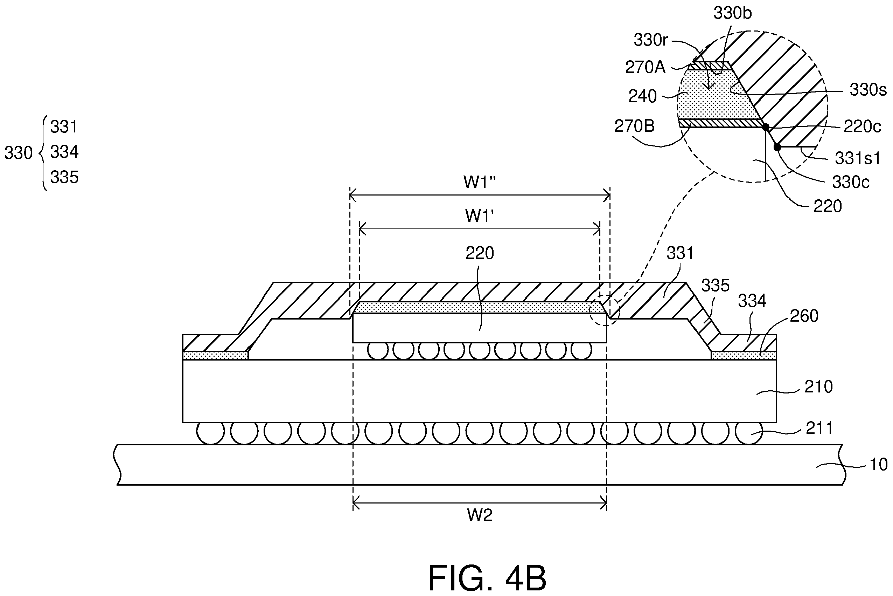

Referring to FIGS. 4A to 4B, FIG. 4A illustrates a diagram view of a top view of a semiconductor device 300 according to an embodiment of the invention, and FIG. 4B illustrates a cross-sectional view of the semiconductor device 300 of FIG. 4A along a direction 4B-4B'.

As illustrated in FIGS. 4A and 4B, the semiconductor device 300 includes the substrate 210, at least one electronic component 220, a cover 330, the liquid metal 240, the adhesive layer 260, the first binding promoting layer 270A and the second binding promoting layer 270B. The electronic component 220 is disposed on the substrate 210. The cover 330 is disposed on the substrate 210, covers the electronic component 220 and has a recess 330r. The liquid metal 240 is formed between the recess 330r and the electronic component 220. As a result, the recess 330r could limit the flowing of the liquid metal 240 to prevent the liquid metal 240 from being overflow.

In an embodiment, the recess 330r could be formed by, for example, a stamping process or a machining process.

Referring to FIG. 4B, the cover 330 includes a plate 331, a surrounding portion 334 and a connection portion 335, wherein the connection portion 335 connects the plate 331 with the surrounding portion 334. The adhesive layer 260 is formed between the surrounding portion 334 and the substrate 210. The connection portion 335 is obliquely connected to the plate 331 and/or the surrounding portion 334. In an embodiment, the cover 330 could be formed by, for example, a stamping process.

Referring to FIG. 4B, the recess 330r has a bottom surface 330b and a lateral surface 330s, and the lateral surface 330s is inclined relative to the bottom surface 330b. Furthermore, the recess 330r has a plurality of first widths, the electronic component 220 has a second width, one of the first widths is smaller than the second width, and another of the first widths is greater than the second width. For example, the bottom surface 330b has a first width W1', and an opening of the recess 330r has a first width W1", wherein the first width W1' is smaller the second width W2, and the first width W1" is greater than the second width W2.

Referring to FIG. 4B, the electronic component 220 has at least one corner 220c, and the corner 220c is in contact with the lateral surface 330s. In another embodiment, the corner 220c of the electronic component 220 could is in contact with a corner 330c of a first surface 331s1 of the cover 330 and the lateral surface 330s. As a result, the recess 330r and the electronic component 220 could limit the flowing of the liquid metal 240 to prevent the liquid metal 240 from being overflow.

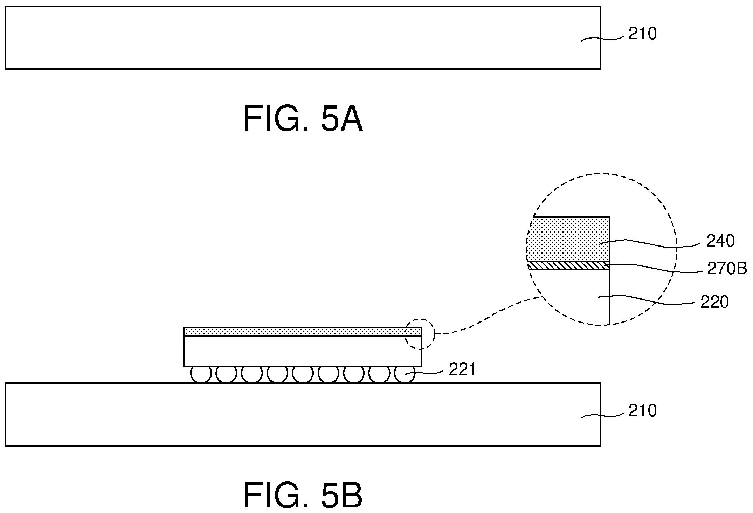

Referring to FIGS. 5A to 5D, FIGS. 5A to 5D illustrate manufacturing processes of the semiconductor device 200 of FIG. 3A.

As illustrated in FIG. 5A, the substrate 210 is provided.

As illustrated in FIG. 5B, at least one electronic component 220 is disposed on the substrate 210 through at least one conductive portion 221. The second binding promoting layer 270B could be pre-formed on the electronic component 220. Then, the liquid metal 240 is formed on the electronic component 220 through the second binding promoting layer 270B.

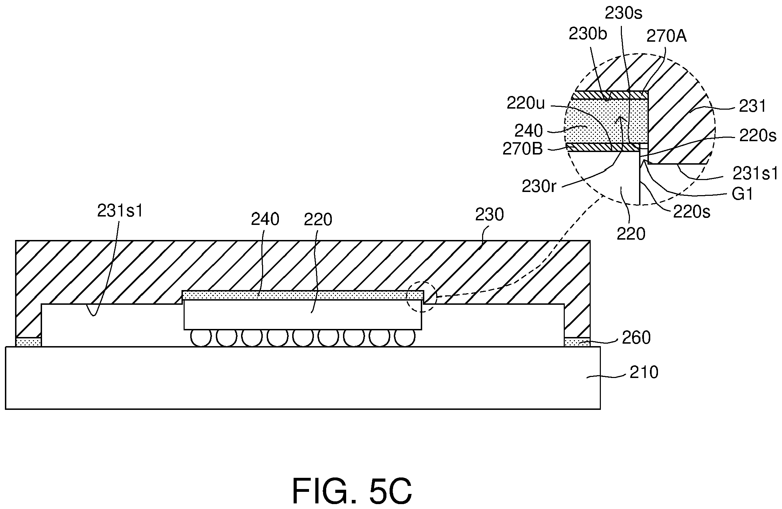

As illustrated in FIG. 5C, the cover 230 is disposed on the substrate 210 and covers the electronic component 220. The cover 230 has the recess 230r.

In FIG. 5C, the recess 230r is recessed with respect to the first surface 231s1 of the cover 230, and the first surface 231s1 is lower than the upper surface 220u of the electronic component 220. As a result, a gap G1 (if any) between a lateral surface 230s of the recess 230r and a lateral surface 220s of the electronic component 220 could block an overflow of the liquid metal 240.

In FIG. 5C, the first binding promoting layer 270A could be pre-formed on the cover 230. For example, the first binding promoting layer 270A is pre-formed on the bottom surface 230b of the recess 230r. Then, the cover 230 is disposed on the substrate 210 and covers the electronic component 220, wherein the liquid metal 240 is formed between the cover 230 and the electronic component 220 or fills space between the cover 230 and the electronic component 220.

. In FIG. 5C, the cover 230 and the substrate 210 are connected through the adhesive layer 260. Then, the adhesive layer 260 could be cured at a temperature of about 120 °C to about 150 °C. Due to the liquid metal 240 being restricted in the recess 230r, the liquid metal 240 is prevented from being flowing out of the gap G1, flowing to the substrate 210 or the lateral surface 220s of the electronic component 220 near the substrate 210 during curing process for the adhesive layer 260.

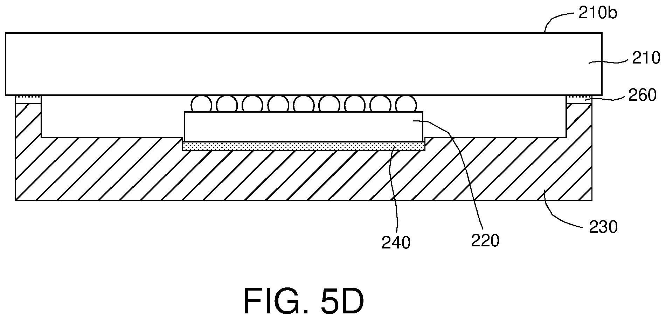

As illustrated in FIG. 5D, the structure in FIG. 5C is inverted to make a bottom surface 210b face upward. Then, at least one solder ball 211 is formed on the bottom surface 210b and cured through the reflow process. Due to the liquid metal 240 being restricted in the recess 230r, the liquid metal 240 is prevented from being flowing out of the gap G1, flowing to the substrate 210 or the lateral surface 220s of electronic component 220 near the substrate 210 during reflow process for the solder ball 211. Then, the substrate 210 may be disposed on the PCB 10 through the solder ball 211.

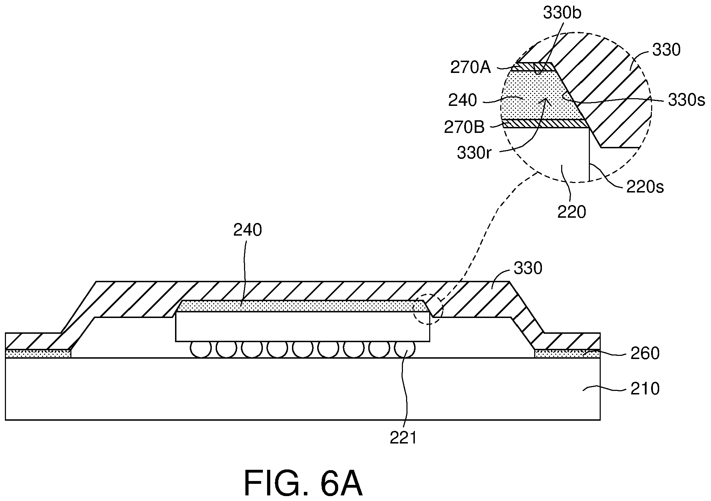

Referring to FIGS. 6A to 6B, FIGS. 6A to 6B illustrate manufacturing processes of the semiconductor device 300 of FIG. 4A.

As illustrated in FIG. 6A, the substrate 210 is provided. Then, at least one electronic component 220 is disposed on the substrate 210 through at least one conductive portion 221. The second binding promoting layer 270B could be pre-formed on the electronic component 220. Then, the liquid metal 240 is formed on the electronic component 220 through the second binding promoting layer 270B. The first binding promoting layer 270A could be pre-formed on the cover 330. For example, the first binding promoting layer 270A is pre-formed on the bottom surface 330b of the recess 330r. Then, the cover 330 is disposed on the substrate 210 and covers the electronic component 220, wherein the liquid metal 240 is formed between the cover 330 and the electronic component 220 or fills space between the cover 330 and the electronic component 220.

As illustrated in FIG. 6A, the cover 330 and the substrate 210 are connected through the adhesive layer 260. Then, the adhesive layer 260 could be cured at a temperature of 120 °C to 150 °C. Due to the liquid metal 240 being restricted in the recess 330r, the liquid metal 240 is prevented from being flowing to the substrate 210 or the lateral surface 220s of the electronic component 220 near the substrate 210 during curing process for the adhesive layer 260.

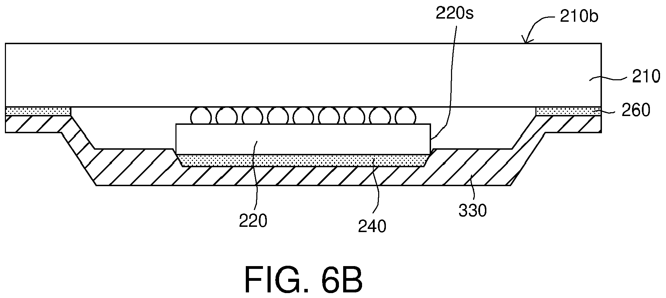

As illustrated in FIG. 6B, the structure in FIG. 6A is inverted to make the bottom surface 210b face upward. Then, at least one solder ball 211 is formed on the bottom surface 210b and cured through the reflow process. Due to the liquid metal 240 being restricted in the recess 330r, the liquid metal 240 is prevented from being flowing to the substrate 210 or the lateral surface of the electronic component 220 near the substrate 210 during reflow process for the solder ball 211.

While the invention has been described in terms of what is presently considered to be the most practical and preferred embodiments, it is to be understood that the invention need not be limited to the disclosed embodiment. On the contrary, it is intended to cover various modifications and similar arrangements included within the scope of the appended claims which are to be accorded with the broadest interpretation so as to encompass all such modifications and similar structures.

## Claims

1. A semiconductor device (200, 300), **characterized in that** the semiconductor device (200, 300) comprises:
a substrate (210);
an electronic component (220) disposed on the substrate (210);
a cover (230, 330) disposed on the substrate (210), covering the electronic component (220) and having a recess (230r, 330r);
a liquid metal (240) formed between the recess (230r, 330r) and the electronic component (220).

2. The semiconductor device (200, 300) as claimed in claim 1, **characterized in that** the electronic component (220) has an upper surface (220u), and the cover (230, 330) comprises:
a plate (231, 331) having a first surface (231s1, 331s1) facing the electronic component (220);
wherein the recess (230r, 330r) is recessed with respect to the first surface (231s1, 331s1), and the first surface (231s1, 331s1) is lower than the upper surface (220u) of the electronic component (220).

3. The semiconductor device (200, 300) as claimed in claim 1 or claim 2, **characterized in that** the recess (230r, 330r) has a first width (W1, W1'), the electronic component (220) has a second width (W2), and the first width (W1, W1') is greater the second width (W2).

4. The semiconductor device (200, 300) as claimed in claim 3, **characterized in that** a ratio of the first width (W1, W1') to the second width (W2) ranges between 1.05 and 1.10.

5. The semiconductor device (200, 300) as claimed in claim 1 or claim 2, **characterized in that** the recess (230r, 330r) has a plurality of first widths (W1, W1'), the electronic component (220) has a second width (W2), one of the first width (W1, W1') is smaller than the second width (W2), and another of the first widths (W1, W1') is greater than the second width (W2).

6. The semiconductor device (200, 300) as claimed in claim 1, **characterized in that** the cover (230, 330) comprises:
a plate (231, 331) having a first surface (231s1, 331s1) facing the electronic component (220);
a surrounding portion (234, 334) disposed on the plate (231, 331) and protruding with respect to the first surface (231s1, 331s1);
wherein the semiconductor device (200, 300) further comprises an adhesive layer (260) formed between the surrounding portion (234, 334) and the substrate (210).

7. The semiconductor device (200, 300) as claimed in any one of the preceding claims, **characterized in that** the recess (230r, 330r) has a depth (d1) ranging between 20 µm and 500 µm.

8. The semiconductor device (200, 300) as claimed in any one of the preceding claims, **characterized in that** the recess (230r, 330r) has a bottom surface (230b, 330b) and a lateral surface (230s, 330s), and the lateral surface (230s, 330s) is inclined relative to the bottom surface (230b, 330b).

9. The semiconductor device (200, 300) as claimed in any one of claims 1 to 7, **characterized in that** the recess (230r, 330r) has a bottom surface (230b, 330b) and a lateral surface (230s, 330s), and the lateral surface (230s, 330s) is vertical to the bottom surface (230b, 330b).

10. The semiconductor device (200, 300) as claimed in any one of claims 1 to 7, **characterized in that** the recess (230r, 330r) has a lateral surface (230s, 330s), the electronic component (220) has an corner, and the corner is in contact with the lateral surface (230s, 330s).

11. The semiconductor device (200, 300) as claimed in any one of the preceding claims, **characterized in that** the liquid metal (240) has melting point ranging between 100°C to 200°C.

12. A manufacturing method, comprising:
disposing an electronic component (220) on a substrate (210);
disposing a cover (230, 330) on the substrate (210) to cover the electronic component (220), wherein the cover has recess (230r, 330r); and
forming a liquid metal (240) between the recess (230r, 330r) and the electronic component (220).

13. The manufacturing method as claimed in claim 12, **characterized in that** the liquid metal (240) has melting point ranging between 100°C to 200°C.

14. The manufacturing method as claimed in claim 12 or 13, **characterized in that** the manufacturing method further comprises:
forming a binding promoting layer (270A, 270B) between cover (230, 330) and the liquid metal (240).

15. The manufacturing method as claimed in claim 12 or 13, **characterized in that** the manufacturing method further comprises:
forming a binding promoting layer (270A, 270B) between the electronic component (220) and the liquid metal (240).
